# EUROPÄISCHE PATENTANMELDUNG

(11) **EP 2 425 969 A1**
(43) Veröffentlichungstag der Anmeldung: **07.03.2012**
(21) Anmeldenummer: 10175339.0
(22) Anmeldetag: 05.09.2010
(51) Int. Cl.: B32B 17/10, H01L 31/048

(54) **Photovoltaikmodule mit mineralischen Füllstoff enthaltenden Klebefolien auf Basis Polyvinylacetal**

(71) Anmelder: Kuraray Europe GmbH, 65926 Frankfurt am Main (DE)
(72) Erfinder: Die Erfindernennung liegt noch nicht vor
(74) Vertreter: Kisters, Michael Marcus

(57) **Zusammenfassung**

Die Erfindung betrifft Photovoltaikmodul mit einer Klebefolie die mindestens 10 Gew.% eines mineralischen Füllstoffs mit einem Brechungsindex von kleiner 1.7 enthält.

## Beschreibung

### Technisches Gebiet

Die Erfindung betrifft die Herstellung von Photovoltaikmodulen unter Verwendung von anorganischen Füllstoff enthaltenden Klebefolien, insbesondere auf Basis weichmacherhaltigem Polyvinylacetal.

### Stand der Technik

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf eine meist transparente Platte z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines in der Regel transparenten Klebers laminiert.

Der Kleber muss die photosensitive Halbleiterschicht und deren elektrische Verbindungsleitungen vollständig umschließen, UVstabil und Feuchtigkeitsunempfindlich sein und nach dem Laminierprozess vollständig blasenfrei sein.

Verfahren zur Herstellung von Solarmodulen mit Hilfe von weichmacherhaltigen Folien auf Basis von Polyvinylacetalen, insbesondere Polyvinylbutyral (PVB) sind z. B. aus DE 40 26 165 C2, DE 42 278 60 A1, DE 29 237 70 C2, DE 35 38 986 C2 oder US 4,321,418 bekannt. Die Verwendung von PVB-Folien in Solarmodulen als Verbundsicherheitsverglasungen ist z.B. in DE 20 302 045 U1, EP 1617487 A1, und DE 35 389 86 C2 offenbart.

Je nach Technologie kann die Klebefolie im Photovoltaikmodul vor oder hinter der photoaktiven Absorberschicht angeordnet sein. Befindet sich die Klebefolie vor der Absorberschicht auf der dem Licht zugewandten Seite, muss die Klebefolie eine möglichst hohe Lichttransmission aufweisen, was bei Verwendung von aus dem Sicherheitsglasbereich bekannter PVB-Folie gegeben ist. Befindet sich die Klebefolie hinter der Absorberschicht auf der dem Licht abgewandten Seite, besteht diese Anforderung nicht länger. In diesem Fall kommt es darauf an, eine dauerhafte Verklebung mit einem nach Möglichkeit kostengünstigem Produkt zu realisieren, wobei Transparenz, Opazität und Farbe unter Umständen lediglich als Designmerkmal anzusehen sind. Als Ausnahme hiervon können Klebefolien betrachtet werden, welche Opak sind und das Licht direkt oder indirekt in die photosensitive Halbleiterschicht reflektieren.

Das auf die photosensitive Schicht der Solarmodule auftretende Sonnenlicht durchdringt diese teilweise und geht damit für eine Umwandlung in elektrische Energie teilweise verloren. Um den Wirkungsgrad von Solarmodulen zu verbessern, werden diese häufig mit einer reflektierenden Rückseite ausgerüstet. Hierzu werden z.B. eine Spiegelschicht oder reflektierende Pigmente in Form einer zusätzlichen Schicht auf die Module aufgebracht. Dieses Verfahren ist aufwändig, da so in das Solarmodul eine zusätzliche Schicht eingebraucht werden muss. Zudem dürfen die elektrisch leitfähigen Spiegelschichten oder reflektierende Pigmente nicht in Kontakt mit der photosensitiven Schicht treten, da sonst die Gefahr von Kurzschlüssen besteht.

Ein zunehmend wichtiger werdendes Merkmal der Klebefolien für Photovoltaikmodule ist deren elektrische Leitfähigkeit, da mit zunehmender Leistungsfähigkeit der photosensitiven Halbleiterschichten bei gleichzeitigem Einsatz auch unter humiden Umweltbedingungen immer höhere Anforderungen an die Isolationsfähigkeit der Folie gestellt werden.

Ladungsverluste oder gar Kurzschlüsse der Halbleiterschicht müssen auch unter extremen Witterungsbedingungen wie tropische Temperaturen, hohe Luftfeuchtigkeit oder starke UV-Strahlung über die gesamte Lebensdauer des Moduls vermieden werden. Photovoltaikmodule werden dem nach IEC 61215 einer Vielzahl von Tests unterzogen (Damp heat test, wet leakage current test) um Verlustströme der Module in der Designphase zu erkennen. Um Verlustströme zu minimieren, müssen die Klebefolien dementsprechend einen möglicht hohen spezifischen Widerstand aufweisen.

Ein Nachteil von Polyvinylacetal-Folien in der Anwendung Photovoltaikmodul sind deren relativ hohe Herstellkosten, da das Polyvinylacetal über mehrere Stufen aus Vinylacetat gewonnen wird.

### Aufgabe

Aufgabe der vorliegenden Erfindung ist es daher, Photovoltaikmodule mit einer elektrisch isolierenden Klebeschicht auf Basis von weichgemachtem Polyvinylacetal auszurüsten, welche in der Herstellung besonders günstig ist.

### Darstellung der Erfindung

Gegenstand der vorliegenden Erfindung sind daher Photovoltaikmodule, umfassend
a) eine transparenten Frontabdeckung
b) eine oder mehrere photosensitive Halbleiterschicht
c) mindestens eine Klebefolie auf Basis von Polyvinylacetal und
d) eine rückwärtige Abdeckung
wobei mindestens eine Klebefolie c) mindestens 10 Gew.% eines mineralischen Füllstoffs mit einem Brechungsindex von kleiner 1.7 enthält.

Im Rahmen der vorliegenden Erfindung werden anorganische Materialien mit einem Brechungsindex kleiner 1.7 als mineralische Füllstoffe und Materialien mit einem Brechungsindex größer 1.7 als (weiß) reflektierende Pigmente bezeichnet. Beispielsweise werden im "Plastics Additives Handbook" (5th Edition, Hanser Verlag, Herausgegeben von Hans Zweifel) für Kreide und Talk als typische anorganische Füllstoffe Brechungsindices von 1.48 - 1.65 bzw. 1.57 - 1.59 angegeben wogegen die Weißpigmente Titandioxid (in der Rutilmodifikation) und Zinkoxid Brechungsindices von 2.7 bzw. 2.0 aufweisen.

Durch Verwendung von mineralischen Füllstoffen werden die Materialkosten gegenüber einer keinen Füllstoff enthaltenden Klebefolie stark verringert. Die durch den Füllstoffanteil verursachte Eintrübung der normalerweise hochtransparenten weichgemachten Polyvinylacetal-Folie beeinträchtigt in keiner Weise die Funktion eines Photovoltaikmoduls, wenn sich die Klebefolie auf der Rückseite (der dem Licht abgewandten Seite) der photosensitiven Halbleiterschicht (der Solarzellen) befindet.

Der Anteil an mineralischem Füllstoff an der Klebefolie beträgt mehr als 10 Gew.-%, bevorzugt mehr als 20 Gew.-%, besonders bevorzugt mehr als 30 Gew.-%, insbesondere mehr als 40 Gew.-% und am meisten bevorzugt mehr als 50 Gew.-%, jeweils bezogen auf die Folienmischung. Auf der anderen Seite sollte der Anteil an mineralischem Füllstoff 80 Gew.-% nicht überschreiten, da die Klebefolie dann keine ausreichende Elastizität mehr aufweist und zu spröde ist.

Bevorzugt wird im Rahmen der Erfindung als mineralischer Füllstoff mindestens ein anorganischer Stoff, ausgewählt aus der Gruppe Kreide (CaCO₃), Magnesiumcarbonat, Calciumsulfat, Bariumsulfat, Talk, Mika, Kaolin, Feldspat, Glasmehl, Aluminiumhydroxid und Magnesiumhydroxid verwendet.

Bevorzugt wird Kreide (CaCO₃, z.B. erhalten durch Fällung oder durch Mahlen von Dolomit, Marmor, Kalkstein usw.) eingesetzt, da diese besonders preiswert erhältlich ist und aufgrund ihrer leichten Basizität gut mit weichgemachtem Polyvinylacetal verträglich ist. Bevorzugt weist die Kreide dabei einen Eisenoxidanteil von weniger als 0.5 Gew.-%, bevorzugt 0.1 Gew.-% und am meisten bevorzugt weniger als 0.05 Gew.-% auf, damit die Klebefolie nicht gelb erscheint und keine nachteiligen Effekte bezüglich Dauerhaftigkeit auftreten.

Da eine die genannten mineralischen Füllstoffe enthaltende Klebefolie auf Basis weichgemachten Polyvinylacetals optisch eher grau erscheint, kann diese zur Erzielung eines ansprechenderen Farbeindruckes mit geringen Mengen (0,01 bis 5 Gew.-%) an farbigen oder farblosen Pigmenten wie Titandioxid, Kobaltblau oder Ruß eingefärbt werden.

Die Klebefolie kann aus mehreren Teilschichten bestehen, welchen nicht alle den mineralischen Füllstoff enthalten müssen bzw. nicht alle zusätzlich farbigen oder farblose Pigmente enthalten müssen. So kann z.B. eine transparente (Füllstofffreie und Pigmentfreie) Teilfolie die notwendige Klebewirkung an Glas herstellen und eine mindestens weitere Teilfolie die mineralischen Füllstoffe und/oder farbigen oder farblosen Pigmente enthalten. Insbesondere kann eine Teilfolie die mineralischen Füllstoffe und optional farbige oder farblose Pigmente enthalten und zwischen zwei transparente (Füllstofffreie und Pigmentfreie) Teilfolien eingebettet sein.

Folien mit mehreren Teilschichten können durch Zusammenlegen von vorgefertigten Teilschichten oder durch Coextrusion der Teilschichten in einem Arbeitsgang hergestellt werden.

Zusätzlich kann die erfindungsgemäß eingesetzte Klebefolie reflektierend ausgerüstet sein, was zu einer Effizienzsteigerung der Photovoltaikmodule führt. Effizienzsteigerung bedeutet, das Photovoltaikmodule gleicher Leistung eine um die Leistungssteigerung kleinere Fläche aufweisen können.

Bevorzugt enthält die mineralisch gefüllte Klebefolie zusätzlich reflektierende Pigmente d.h. Pigmente mit einem Brechungsindex von mehr als 1.7.

Unter Reflektion wird im Rahmen der vorliegenden Erfindung eine Reflektion der für die photosensitive Halbleiterschicht in elektrische Energie umwandelbare Strahlung, in der Regel die Strahlung im UV-Bereich, dem Wellenlängenbereich des sichtbaren Lichts und des nahen IR-Bereichs, verstanden.

Durch die diffus reflektierend ausgerüstete Klebefolie wird ein Teil des Lichts, das die photosensitive Halbleiterschicht durchdringt, wieder auf diese zurückreflektiert, sodass sich die Effektivität des Moduls erhöht. Entscheidend für die Effizienzverbesserung der erfindungsgemäßen Photovoltaikmodule ist d e r Strahlungsreflexionsgrad bzw. die Reflexionseigenschaften der reflektierenden Klebefolie. Dieser wird, wie in den Beispielen angegeben, an glatten (d.h. abgepressten) Folien gemäß DIN EN 410 bestimmt und beträgt mindestens 15 % oder 25 %, mindestens jedoch 30 %, bevorzugt mindestens 50 % und insbesondere mindestens 70 %. Insbesondere kann zusätzlich die bei der Einzelwellenlänge 1100 nm gemessene Reflektion mehr als 80%, bevorzugt mehr als 85% und besonders bevorzugt mehr als 90% betragen.

Solche Messungen können auf einem UV/VIS-Spektrometer "Lambda 950" des Herstellers Perkin-Elmer durchgeführt werden. Nach DIN EN 410 wird der Strahlungsreflexionsgrad im Wellenlängenbereich 300 - 2500 nm bestimmt.

Als reflektierende Pigmente sind insbesondere die sogenannten Weißpigmente, dass heißt Pigmente mit einem Brechungsindex von mehr als 1.7 gut geeignet. Hierzu zählen ein oder mehrere Weißpigmente der Gruppe Titandioxid, Lithopone, Zinkoxid, Zinksulfid und Bleicarbonat. Alternativ oder zusätzlich können als reflektierende Pigmente auch ein oder mehrere Metalle der Gruppe Al, Zn, Cr, oder Ti eingesetzt werden.

Der Anteil der reflektierenden Pigmente mit einem Brechungsindex von mehr als 1.7 in der Klebefolie beträgt bevorzugt 0.1 bis 25 Gew.%, insbesondere 5 bis 20 Gew.%, besonders bevorzugt 7.5 bis 15 Gew.%. Ist die Klebefolie aus mehreren Teilschichten aufgebaut, so bezieht sich dieser Wert auf die Gesamtfolie, so dass in der pigmenthaltigen und/oder mineralstoffhaltigen Teilschicht entsprechend der Dickenverteilung höhere Konzentrationen der jeweiligen Materialien vorliegen können.

Im Fall, das die Zwischenschicht aus mindestens einer pigmentfreien/füllstofffreien und mindestens einer pigmenthaltigen/füllstoffhaltigen Teilschicht besteht, können diese Teilschichten jeweils eine unterschiedliche oder gleiche Zusammensetzung bzw. polymere Materialien enthalten.

Die weichmacherhaltiges Polyvinylacetal enthaltenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Es ist auch möglich, die Acetalisierung mit anderen oder weiteren Aldehyden mit 5-10 Kohlenstoffatomen (z.B. wie Valeraldehyd) durchzuführen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98% hydrolysiert und enthalten 1 bis 10 Gew. auf Ethylen basierende Einheiten (z.B. Typ "Exceval" der Kuraray Europe GmbH).

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil im Bereich zwischen 12 - 22 Gew.%, bevorzugt zwischen 14 - 21 Gew.% und besonders bevorzugt zwischen 16 - 20 Gew.% auf.

Der Polyvinylacetatanteil der erfindungsgemäß verwendeten Polyvinylacetale liegt bevorzugt unter 5 Gew.%, bevorzugt unter 3 Gew.% und insbesondere unter 2 Gew.% Aus dem Polyvinylalkoholanteil und dem Restacetatgehalt kann der Acetalisierungsgrad rechnerisch ermittelt werden.

Die erfindungsgemäß eingesetzten Folien weisen bei einer Umgebungsfeuchte von 85% rF bei 23°C bevorzugt einen spezifischen Widerstand von mindestens 1E+11 ohm*cm, bevorzugt mindestens 5E+11 ohm*cm, bevorzugt 1E+12 ohm*cm, bevorzugt 5E+12 ohm*cm, bevorzugt 1E+13, bevorzugt 5E+13 ohm*cm, bevorzugt 1E+14 ohm*cm auf.

Bevorzugt weisen die erfindungsgemäß eingesetzten Folien, insbesondere solche auf Basis von weichmacherhaltigem Polyvinylacetal, einen Weichmachergehalt von maximal 40 Gew.%, 30 Gew.%, 26 Gew.%, 22 Gew.%, 18 Gew.%, 16 Gew.% auf, wobei ein Weichmachergehalt von 5 Gew.% aus Gründen der Verarbeitbarkeit der Folie nicht unterschritten werden sollte (jeweils bezogen auf die gesamte Folienformulierung). Erfindungsgemäß verwendete Folien können einen oder mehrere Weichmacher enthalten.

Durch die Verwendung von mineralischen Füllstoffen wird die Haftung der Klebefolie an Glasoberflächen zusätzlich erhöht, was für die Dauerstabilität der Photovoltaikmodule sowie zur Minimierung von Leckströmen von Vorteil ist.

Die Bestimmung der Kompressionsscherhaftung erfolgt nach den im Folgenden genauer beschriebenen, in Anlehnung an die in EP 0 067 022 A1 genannte Methode. Alle Prüfungen erfolgen an Glas/Glaslaminaten mit identischem Aufbau wie die erfindungsgemäßen Solarmodule, jedoch ohne Solarzellen.

Zur Verwendung in erfindungsgemäßen Solarmodulen geeignete PVB-Folien weisen bevorzugt eine Kompressionsscherhaftung an Luft/Luft-Seiten von Glasoberflächen von 20 - 70 N/mm2, bevorzugt 30 - 60 N/mm2 und insbesondere 35 - 55 N/mm2 auf.

Die Kompressionsscherhaftung dieser Folien an Glasoberflächen bezüglich der Zinn/Zinn-Seiten von Glas beträgt vorzugsweise 15 - 60 N/mm2, bevorzugt 20 - 55 N/mm2. Bei Messung der Kompressionsscherhaftung an Glasoberflächen in Luft/Zinn-Orientierung weisen die erfindungsgemäßen Folien entsprechende Zwischenwerte im Bereich 15 - 70 N/mm2 auf.

Grundsätzlich geeignete Weichmacher für die erfindungsgemäß eingesetzten Folien auf Basis von Polyvinylacetalen sind eine oder mehrere Verbindungen ausgewählt aus den folgenden Gruppen:
- Ester von mehrwertigen aliphatischen oder aromatischen Säuren , z.B. Dialkyladipate wie Dihexyladipat, Dioctyladipat, Hexylcyclohexyladipat, Mischungen aus Heptylund Nonyladipaten, Diisononyladipat, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykolbis-(2-ethylhexanoat), Triet hylenglykol-bis- (2-ethylhexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat, Tetraethylenglykoldimethylether und/oder Dipropylenglykolbenzoat

- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Gut geeignet als Weichmacher für die erfindungsgemäß eingesetzten Folien auf Basis von Polyvinylacetalen sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), 1,2-Cyclohexandicarbonsäurediisononylester (DINCH) und Dipropylenglykolbenzoat.

Ganz besonders geeignet als Weichmacher für die erfindungsgemäß eingesetzten Folien auf Basis von Polyvinylacetalen sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | Abkürzung | 100 x O/(C+H) |
|---|---|---|
| Di-2-ethylhexylsebacat | (DOS) | 5,3 |
| 1,2-Cyclohexandicarbonsäurediisononylester | (DINCH) | 5,4 |
| Di-2-ethylhexyladipat | (DOA) | 6,3 |
| Di-2-ethylhexylphthalat | (DOP) | 6,5 |
| Dihexyladipat | (DHA) | 7,7 |
| Dibutylsebacat | (DBS) | 7,7 |
| Triethylenglykol-bis-2-propylhexanoat | | 8,6 |
| Triethylenglykol-bis-i-nonanoat | | 8,6 |
| Di-2-butoxyethylsebacat | (DBES) | 9,4 |
| Triethylenglykol-bis-2-ethylhexanoat | (3G8) | 9,4 |

Das Haftungsvermögen von Polyvinylacetalfolien an Glas wird üblicherweise durch die Zugabe von Haftungsregulatoren wie z. B. die in WO 03/033583 A1 offenbarten Alkali- und/oder Erdalkalisalze von organischen Säuren eingestellt. Als besonders geeignet haben sich Kaliumacetat und/oder Magnesiumacetat herausgestellt. Zudem enthalten Polyvinylacetale aus dem Herstellungsprozess häufig Alkaliund/oder Erdalkalisalze von anorganischen Säuren, wie z.B. Natriumchlorid.

Da Salze ebenfalls einen Einfluss auf den spezifischen Widerstand haben, ist der Einsatz von weichmacherhaltigen, auf Polyvinylacetal basierenden Folien (bezogen auf Polyvinylacetal und Weichmacher) mit weniger als 50 ppm, besonders bevorzugt mit weniger als 30 ppm und insbesondere mit weniger als 20 ppm Metallionen zweckmäßig. Dies kann durch entsprechende Waschverfahren des Polyvinylacetals und durch die Verwendung von Magnesium-, Calcium- und/oder Zinksalze organischer Säuren (z.B. Acetate) erreicht werden.

Weiterhin kann die möglicherweise vom Wassergehalt der Folie abhängende Ionenbeweglichkeit und damit der spezifische Widerstand durch den Zusatz von pyrogener Kieselsäure beeinflusst werden. Bevorzugt enthalten die weichmacherhaltigen, auf Polyvinylacetal basierenden Folien 0.001 bis 15 Gew.%, bevorzugt 2 bis 5 Gew.% pyrogenes SiO₂.

Weiterhin können die erfindungsgemäßen Mischungen oder Folien zusätzlich weitere Additive, wie zum Beispiel Antistatika, Füllstoffe, IR-Absorbierende Nanopartikel bzw. Chromophore, Farbstoffe, oberflächenaktive Substanzen, Bleichmittel, Stabilisatoren, Säure/Base-Puffer, Chelatbildner, Epoxygruppen enthaltende Verbindungen, Korrosionshemmer (z.B. stickstoffhaltige Heterocyclen) Pigmente sowie Haftungsregulatoren enthalten.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Laminierung der Photovoltaikmodule erfolgt unter Verschmelzung der Folien, so dass ein blasen- und schlierenfreier Einschluss der photosensitiven Halbleiterschicht mit den Folien erhalten wird.

Die Gesamtdicke der Klebefolien liegt üblicherweise bei 0.20, 0.38, 0.45, 0.60, 0.76 oder 1.14 mm.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolierverglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Werden erfindungsgemäße Dünnschicht-Solarmodule hergestellt, so sind die photosensitiven Halbleiterschichten (b) in der Regel direkt auf die transparente Frontabdeckung (a) aufgebracht und mit der rückwärtigen Abdeckung (d) durch mindestens eine erfindungsgemäße Klebefolie c) verklebt.

Im Fall der Herstellung von kristallinen oder geträgerten Solarmodulen müssen die Solarmodule von Klebefolien eingekapselt werden, d.h. dass die photosensitiven Halbleiterschichten b) mit mindestens einer, nicht mineralisch gefüllter Klebefolie (e) mit der transparenten Frontabdeckung a) und die rückwärtigen Abdeckung d) durch mindestens eine erfindungsgemäße Klebefolie c) verklebt sind. Die Folien € weisen bevorzugt bis auf den mineralischen Füllstoffanteil und die optional verwendeten weißen oder schwarzen Pigmente eine gleiche Zusammensetzung wie die Folien c) auf.

Zur Laminierung des so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumringverfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbundverglasungen innerhalb von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

Erfindungsgemäße Photovoltaikmodule können als Fassadenbauteil, Dachflächen, Wintergartenabdeckung, Schallschutzwand, Balkonoder Brüstungselement oder als Bestandteil von Fensterflächen verwendet werden.

### Messmethoden:

Die Messung des spezifischen Durchgangswiderstandes der Folie erfolgt gemäß DIN IEC 60093 bei definierter Temperatur und Umgebungsfeuchte (23 °C und 85 % rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5 kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhigkeit R_{z} bei Messung nach DIN EN ISO 4287 nicht größer als 10 µm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Der Wasser- bzw. Feuchtegehalt der Folien wird mit der Karl-Fischer-Methode bestimmt.

Für die angeführten Beispiele wurde der Strahlungsreflexionsgrad einer glatten bzw. geglätteten Seite der Klebefolie auf einem UV/VIS-Spektrometer "Lambda 950" des Herstellers Perkin-Elmer gemäß DIN EN 410 im Wellenlängenbereich 300 - 2500 nm bestimmt. Weil die Messung an einem planen Muster durchgeführt werden soll, kann die Klebefolie zur Messung auf einen transparenten Träger, z.B. einem Stück Glas befestigt werden.

### Kompressionsschertest

Zur Beurteilung der Haftung einer PVB-Folie wird der Kompressionsschertest in Anlehnung an DE 197 56 274 A1 an einem Glas/Glaslaminat ohne Solarzelle oder weitere Funktionsschichten durchgeführt. Zur Herstellung der Prüfkörper wird die zu prüfende PVB-Folie zwischen zwei ebene Silikatglasscheiben des Formats 300 mm x 300 mm mit einer Dicke von 2 mm gebracht, in einem Vorverbundofen mit Kalanderwalzen zu einem Glas-Vorverbund entlüftet und anschließend in einem Autoklav bei einem Druck von 12 bar und bei einer Temperatur von 140 °C innerhalb von insgesamt 90 min. zu einem ebenen Verbundsicherheitsglas verpresst. Aus dem so hergestellten Verbundsicherheitsglas werden 10 Proben mit den Maßen 25,4 mm x 25,4 mm geschnitten. Diese werden unter einem Winkel von 45° in eine Prüfapparatur gemäß DE 197 56 274 A1 eingespannt, wobei die Tiefe der Aussparungen ca. 2/3 der jeweiligen Glasdicke beträgt. Die obere Hälfte wird mit einer stetig steigenden, genau vertikal nach unten gerichteten Kraft beaufschlagt, bis es zu einer Abscherung innerhalb des Prüfkörpers, d. h. der zu prüfenden Verbundsicherheitsglasscheiben, kommt.

Die Prüfparameter sind wie folgt:

| | |
|---|---|
| Prüfkörper: | quadratisch 25,4 mm x 25,4 mm |
| Verlegung: | untere Scheibe jeweils mit der Luft- bzw. Feuerseite zur Folie (Luft/Luft), oder obere und untere Scheibe jeweils mit der Zinnseite zur Folie (Bad/Bad) |
| Lagerung vor dem Versuch: | 4h bei Normklima 23°C/50% RLF |
| Vorschub: | 2,5 mm/min |
| Probenanzahl: | 10 |
| Auswertung: | Maximalkraft, die zur Abscherung der Folie vom Glas benötigt wird. Die Kraft wird auf die Probenfläche bezogen (in N/mm2 oder psi) |

Für jeden Prüfkörper wird die bei der Abscherung ausgeübte Kraft von zehn gleichen Prüfkörpern linear gemittelt. Soweit in den nachfolgenden Beispielen und den Ansprüchen auf den mittleren Kompressionsschertest-Wert Bezug genommen wird, ist damit dieser Mittelwert aus 10 Messungen gemeint. Im übrigen wird auf die DE 197 56 274 A1 verwiesen.

### Beispiele:

Es wurden weichmacherhaltige Polyvinylbutyralfolien in Stärke 0.76 mm mit / ohne mineralischen Füllstoff gemäß der in der Tabelle angegebenen Zusammensetzung auf ihre Eignung als Klebefolie in Photovoltaikmodulen untersucht. Die Folien bestanden aus weichgemachtem Polyvinylbutyral (PVB) mit dem angegebenen Polyvinylalkoholgehalt (PVOH) in Gew.% und einem Polyvinylacetatgehalt von ca. 1 Gew.%. Als Weichmacher wurde ein Gemisch von Triethylenglykol-bis-2-ethylhexanoat (3GO bzw. 3G8) und Di-2-butoxyethyladipat (DBEA) im angegebenen Masseverhältnis eingesetzt.

Die Folien wurde vor dem Einlaminieren in einem Klima von 23 °C / 23 % rF während 24h konditioniert, die Gläser auf einer Glaswaschmaschine mit 50 °C warmen VE-Wasser gereinigt. Die Laminate wurden anschließend in dem für Verbundglas typischen Walze / Autoklav-Verfahren bei einer Maximaltemperatur von 140 °C hergestellt.

Alle Angaben der Tabelle sind in Gew.% bezogen auf die Folienmischung d.h. bezogen auf Summe (PVB, Weichmacher Füllstoff und TiO2). Der PVOH-Gehalt im PVB ist bezogen auf das PVB. Mg(Acetat)2 x 4 H2O wird als in wässriger Lösung als basischer Puffer zugesetzt

OMYACARB 2GU ist eine als Füllstoff für die Kunststoffindustrie verwendete Kreide der Firma Omya, MICRAL OPAC EXTRA ist eine als Füllstoff für die Kunststoffindustrie verwendetes utramicronisierters Calciumcarbonat der Firma Rerverté. KRONOS 2220 ist ein Titandioxid vom Rutil-Typ von der Firma Kronos Titan mit einem Rutilgehalt von weniger als 93 Gew.-%.

Die Werte der folgenden Tabelle zeigen, dass erfindungsgemäß verwendete Zwischenschichtfolien trotz des mineralischen Füllstoffs eine gegenüber keinen mineralischen Füllstoff und kein Titandioxid enthaltender Folie deutlich erhöhte Haftung und optional gutes Reflektionsvermögen aufweisen. Zusätzlich ist die Wasseraufnahme gegenüber den Vergleichsfolien ohne mineralischen Füllstoff verringert und der elektrische Durchgangswiderstand verbessert. Folien dieser Art sind daher besonders zur Herstellung von Photovoltaikmodulen geeignet.

| | **VG 1** | **VG 2** | **Bsp 1** | **Bsp 2** | **Bsp 3** | **Bsp 4** |
|---|---|---|---|---|---|---|
| PVB mit PVOH-Gehalt 20.2 Gew.% | 72,5 | 63,4 | 54,4 | 36,25 | 36,25 | 36,25 |
| 3G8/DBEA 10:1 | 27,5 | 24,1 | 20,6 | 13,75 | 13,75 | 13,75 |
| Magnesiumacetat tetrahydrat | 0,0125 | 0,0125 | 0,0125 | 0,0125 | 0,0125 | 0,0125 |
| OMYACARB2GU | - | - | 25 | 50 | 37,5 | - |
| MICRAL OPAC EXTRA | - | - | - | - | - | 37,5 |
| KRONOS 2220 (TiO2) | - | 12,5 | - | - | 12,5 | 12,5 |
| Haftungsprüfung an Laminat zwischen 2 x 2 mm Planilux in Orientierung Luft/Zinn | | | | | | |
| Vorkonditionierung der Folie im Klimaschrank bei | 23° / 23% | 23° / 23% | 23° / 23% | 23° / 23% | 23° / 23% | 23° / 23% |
| Wassergehalt nach Karl-Fischer | 0,45 | 0,42 | 0,37 | 0,28 | 0,32 | 0,31 |
| Pummelwert Feuer-Seite | 10 | 10 | 10 | 10 | 10 | 10 |
| Pummelwert Zinn-Seite | 8 | 10 | 10 | 10 | 10 | 10 |
| Haftungsprüfung an Laminat zwischen 2 x 2 mm Planilux in Orientierung Luft/Luft bzw. Zinn/Zinn | | | | | | |
| Vorkonditionierung der Folie im Klimaschrank bei | 23° / 23% | 23° / 23% | 23° / 23% | 23° / 23% | 23° / 23% | 23° / 23% |
| Kompressionsschertest in N/mm2 (Luft/Luft) | 26,8 | 44,5 | 49,3 | 51,7 | 53,2 | 52,1 |
| Kompressionsschertest in N/mm2 (Zinn/Zinn) | 22,6 | 37,8 | 42,1 | 46,0 | 50.8 | 49,2 |
| Reflektionseigenschaften der unlaminierten Folie gemäß EN 410 | | | | | | |
| Strahlungsreflexionsgrad | - | 0,86 | 0,52 | 0,59 | 0,80 | 0,84 |
| Reflexionsgrad bei 450 nm | - | 0,97 | 0,58 | 0,63 | 0,91 | 0,93 |
| Reflexionsgrad bei 550 nm | - | 0,98 | 0,59 | 0,65 | 0,91 | 0,94 |
| Reflexionsgrad bei 1100 nm | - | 0,93 | 0,53 | 0,58 | 0,85 | 0,91 |
| Feuchtegehalt und elektrischer Durchgangswiderstand nach 24h Konditionierung bei 23°C / 85% RF | | | | | | |
| Elektrischer Durchgangswiderstand DIN IEC 60093 bei 23°C / 85% RF | 1,4E+12 | 2,2E+12 | 1,6E+12 | 3,4E+12 | 2,1E+13 | 3,4E+13 |
| Wassergehalt nach Karl-Fischer bei 23°C / 85% RF | 2,65 | 2,40 | 2,05 | 1,47 | 1,54 | 1,52 |

## Patentansprüche

1. Photovoltaikmodul, umfassend ein Laminat aus
a) einer transparenten Frontabdeckung
b) einer oder mehreren photosensitiven Halbleiterschichten
c) mindestens eine Klebefolie auf Basis von Polyvinylacetal und
d) einer rückwärtigen Abdeckung
**dadurch gekennzeichnet, dass** mindestens eine Klebefolie © mindestens 10 Gew.% eines mineralischen Füllstoffs mit einem Brechungsindex von kleiner 1.7 enthält.

2. Photovoltaikmodul nach Anspruch 1, **dadurch gekennzeichnet, dass** als mineralischer Füllstoff mindestens ein anorganischer Stoff, ausgewählt aus der Gruppe Kreide (CaCO₃), Magnesiumcarbonat, Calciumsulfat, Bariumsulfat, Talk, Mika, Kaolin, Feldspat, Glasmehl, Aluminiumhydroxid und Magnesiumhydroxid verwendet wird.

3. Photovoltaikmodul nach Anspruch 1 oder 2, **dadurch gekennzeichnet, dass** die Folie zusätzlich 0,01 bis 5 Gew.-% an farbigen Pigmenten enthält.

4. Photovoltaikmodul nach einem der Ansprüche 1 bis 3, **dadurch gekennzeichnet, dass** die Folie zusätzlich 0,1 bis 25 Gew.% mindestens eines reflektierenden Pigments mit einem Brechungsindex größer 1.7 enthält.

5. Photovoltaikmodul nach einem der Ansprüche 1 bis 4 **dadurch gekennzeichnet, dass** die Klebefolie aus mindestens einer füllstofffreien und mindestens einer füllstoffhaltigen Teilschicht besteht.

6. Photovoltaikmodul nach einem der Ansprüche 1 bis 5, **dadurch gekennzeichnet, dass** die Klebefolie weichmacherhaltiges Polyvinylacetal mit einen Polyvinylalkoholanteil von 12 - 22 Gew.% enthält.

7. Photovoltaikmodul nach einem der Ansprüche 1 bis 6 **dadurch gekennzeichnet, dass** die Klebefolie mindestens einen Weichmacher ausgewählt aus der Gruppe Di-2-ethylhexylsebacat (DOS), 1,2-Cyclohexandicarbonsäurediisononylester (DINCH), Diisononyladipat (DINA), Di-2-ethylhexyladipat (DOA), Di-2-ethylhexylphthalat (DOP), Dihexyladipat (DHA), Dibutylsebacat (DBS), Triethylenglykol-bis-2-propylhexanoat, Triethylenglykol-bis-i-nonanoat, Di-2-butoxyethylsebacat (DBES) und Triethylenglykol-bis-2-ethylhexanoat (3G8) aufweist.

8. Photovoltaikmodul nach einem der Ansprüche 1 bis 7 **dadurch gekennzeichnet, dass** die reflektierende Klebefolie bei einer Umgebungsfeuchte von 85% rF bei 23°C einen spezifischen Widerstand von mindestens 1E+11 ohm*cm besitzen.

9. Photovoltaikmodul nach einem der Ansprüche 1 bis 8 **dadurch gekennzeichnet, dass** die reflektierende Klebefolie eine Kompressionsscherhaftung an den Luft/Luft-Seiten von Glas von 20 - 70 N/mm2 aufweist

10. Photovoltaikmodul nach einem der Ansprüche 1 bis 8 **dadurch gekennzeichnet, dass** die reflektierende Klebefolie eine Kompressionsscherhaftung an den Zinn/Zinn-Seiten von Glas Glases von 15 - 60 N/mm2 aufweist.

11. Photovoltaikmodul nach einem der Ansprüche 1 bis 10 **dadurch gekennzeichnet, dass** die photosensitiven Halbleiterschichten (b) auf die transparente Frontabdeckung (a) aufgebracht und mit der rückwärtigen Abdeckung (d) durch eine Klebefolie (c) verklebt sind.

12. Photovoltaikmodul nach einem der Ansprüche 1 bis 10 **dadurch gekennzeichnet, dass** die photosensitiven Halbleiterschichten b) mit mindestens einer, nicht mineralisch gefüllten Klebefolie (e) mit der transparenten Frontabdeckung a) und die rückwärtigen Abdeckung d) durch mindestens eine Klebefolie c) verklebt sind.
